# EUROPEAN PATENT APPLICATION

(11) **EP 4 391 006 A1**
(43) Date of publication of application: **26.06.2024**
(21) Application number: 22215815.6
(22) Date of filing: 22.12.2022
(51) Int. Cl.: H01J 37/02, H01J 37/12, H01J 37/28

(54) **CHARGED PARTICLE APPARATUS, METHOD OF PROJECTING CHARGED PARTICLES, METHOD OF ASSESSING A SAMPLE**

(71) Applicant: ASML Netherlands B.V., 5500 AH Veldhoven (NL)
(72) Inventor: RODRIGUES MANSANO, Andre, Luis, 5500 AH Veldhoven (NL); SLOT, Erwin, 5500 AH Veldhoven (NL); VAN LEEUWEN, Richard, Michel, 5500 AH Veldhoven (NL)
(74) Representative: ASML Netherlands B.V.

(57) **Abstract**

The present disclosure relates to a charged particular apparatus for projecting a multi-beam of charged particles toward a sample. In one arrangement, a sample support supports a sample. A charged particle-optical device projects beams of a multi-beam of the charged particles along a plurality of paths toward the sample. The device comprises a plurality of charged particle-optical elements that define an objective lens and in which are defined a plurality of apertures along the paths of the beams. At least two of the charged particle-optical elements are configured to be set at different potentials and at least one of the charged particle-optical elements is set at ground potential.

## Description

### FIELD

The embodiments provided herein generally relate to apparatus for directing charged particles such as electrons towards a sample and related apparatus and methods.

### BACKGROUND

When manufacturing semiconductor integrated circuit (IC) chips, undesired pattern defects may occur on a substrate (e.g. wafer) or a mask during the fabrication processes, thereby reducing the yield. Defects may occur as a consequence of, for example, optical effects and incident particles or other processing steps such as etching, deposition or chemical mechanical polishing. Monitoring the extent of the undesired pattern defects is therefore an important process in the manufacture of IC chips. More generally, the inspection and/or measurement of a surface of a substrate, or other object/material, is an important process during and/or after its manufacture.

Pattern assessment systems for example pattern inspection tools with a charged particle beam have been used to assess objects, for example to detect pattern defects. These tools typically use electron microscopy techniques, such as a scanning electron microscope (SEM). In a SEM, a primary electron beam of electrons at a relatively high energy is targeted with a final deceleration step to land on a target at a relatively low landing energy. The beam of electrons is focused as a probing spot on the target. The interactions between the material structure at the probing spot and the landing electrons from the beam of electrons cause electrons to be emitted from the surface, such as secondary electrons, backscattered electrons or Auger electrons, which together may be referred as signal electrons or more generally signal particles. The generated secondary electrons may be emitted from the material structure of the target.

By scanning the primary electron beam as the probing spot over the target surface, secondary electrons can be emitted across the surface of the target. By collecting these emitted secondary electrons from the target surface, a pattern inspection tool (or apparatus) may obtain an image-like signal representing characteristics of the material structure of the surface of the target. In such inspection the collected secondary electrons are detected by a detector within the apparatus. The detector generates a signal in response to the incident charged particles. As an area of the sample is inspected, the signals comprise data which is processed to generate the inspection image corresponding to the inspected area of the sample.

Beams of charged particles such as electrons can be controlled by applying potentials to charged particle-optical elements. The potentials define electric fields that can be used to influence trajectories of charged particles in a desired manner, for example to deflect or focus beams of the charged particles. Where the electric fields are large, such as where a charged particle-optical element is located close to the sample, or where different charged particle-optical elements are close together or where high potential differences are applied, the electric fields may trigger discharge events due to electric breakdown. Such discharges can cause fluctuations in voltage and current in nearby components that can lead to damage of those components. Discharge protection elements such as diodes may provide protection against such damage but may increase system complexity and/or reduce noise performance.

### SUMMARY

It is an object of the present disclosure to at least partially address features of operation of charged particle-optical elements discussed above, including for example to reduce or avoid the risk of component damage from electric discharges.

According to an aspect of the invention, there is provided a charged particle apparatus for projecting a multi-beam of charged particles toward a sample, the apparatus comprising: a sample support configured to support a sample; a charged particle-optical device configured to project beams of a multi-beam of the charged particles along a plurality of paths toward the sample, the device comprising a plurality of charged particle-optical elements that define an objective lens and in which are defined a plurality of apertures along the paths of the beams, wherein: at least two of the charged particle-optical elements are configured to be set at different potentials and at least one of the charged particle-optical elements is set at ground potential.

According to an aspect of the invention, there is provided a method of projecting charged particles toward a sample, the method comprising: using a charged particle-optical device to project beams of a multi-beam of the charged particles along a plurality of paths toward the sample, the device comprising a plurality of charged particle-optical elements that define an objective lens and in which are defined a plurality of apertures along the paths of the beams; and maintaining at least two of the charged particle-optical elements at different potentials and at least one of the charged particle-optical elements at ground potential during the projecting of the beams toward the sample.

Advantages of the present invention will become apparent from the following description taken in conjunction with the accompanying drawings wherein are set forth, by way of illustration and example, certain embodiments of the present invention.

### BRIEF DESCRIPTION OF FIGURES

The above and other aspects of the present disclosure will become more apparent from the description of exemplary embodiments, taken in conjunction with the accompanying drawings.
**FIG.** 1 is a schematic diagram illustrating an exemplary assessment apparatus.
**FIG. 2** is a schematic diagram illustrating an exemplary multi-beam charged particle-optical device that is part of the exemplary assessment apparatus of **FIG. 1****.**
**FIG. 3** is a schematic diagram of an exemplary charged particle-optical device comprising a collimator element array and a scan-deflector array that is part of the exemplary assessment apparatus of **FIG. 1****.**
**FIG. 4** is a schematic diagram of an exemplary charged particle-optical device array comprising the charged particle-optical devices of **FIG. 3****.**
**FIG. 5** is a schematic diagram of an alternative exemplary charged particle-optical device that is part of the exemplary assessment apparatus of **FIG. 1****.**
**FIG. 6** is a schematic diagram of an alternative exemplary charged particle-optical device that is part of the exemplary assessment apparatus of **FIG. 1****.**
**FIG. 7** is a schematic diagram of an exemplary charged particle-optical module that may be part of the charged particle-optical devices of **FIG. 3****,** **4****,** **5** or **6**.
**FIG. 8** is a schematic sectional view through a first spacer element of the charged particle-optical module of **FIG. 7** viewed along an axis parallel with the paths of the beams of the multi-beam.
**FIG. 9** is a magnified view of a portion of the charged particle-optical module of **FIG. 7****.**
**FIG. 10-12** are magnified views of a portion of the charged particle-optical module of **FIG. 7** showing different exemplary configurations for vias through a detector substrate.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

### DETAILED DESCRIPTION

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%,. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by assessment systems (such as a Scanning Electron Microscope (`SEM')) is desirable for maintaining high yield and low cost for IC chips.

A scanning electron microscope comprises a scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as signal particles e.g. secondary electrons and/or backscattered electrons. Secondary electrons may be considered to have an energy of up to 50eV. Backscatter electrons, although having an energy spectrum from substantially zero to the energy of the maximum of the charged particle device, are conventionally set to electrons (or signal electrons) having an energy exceeding 50eV. The detection apparatus captures the signal particles (e.g. secondary electrons and/or backscattered electrons) from the target as the target is scanned so that the scanning electron microscope may create an image of the scanned area of the target. A design of charged particle-optical apparatus embodying these scanning electron microscope features may have a single beam. For higher throughput such as for assessment, some designs of apparatus use multiple focused beams, i.e. a multi-beam, of primary electrons. The component beams of the multi-beam may be referred to as sub-beams or beamlets. A multi-beam may scan different parts of a target simultaneously. A multi-beam assessment apparatus may therefore assess a target much quicker, e.g. by moving the target at a higher speed, than a single-beam assessment apparatus.

An implementation of a known multi-beam assessment apparatus is described below.

The Figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred with reference to electrons, throughout the present document may therefore be more generally be considered to be references to charged particles, and items referred to in reference to charged particles, with the charged particles not necessarily being electrons.

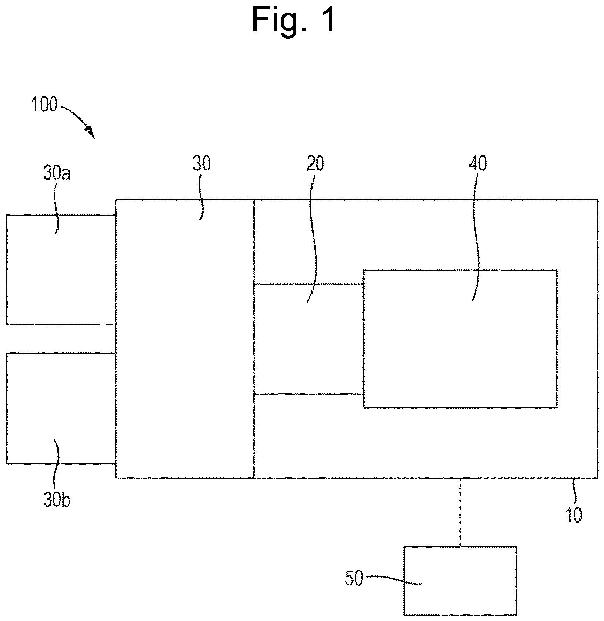

Reference is now made to **FIG. 1****,** which is a schematic diagram illustrating an exemplary assessment apparatus 100, or inspection apparatus. The assessment apparatus 100 of **FIG. 1** includes a vacuum chamber 10, a load lock chamber 20, a charged particle-optical apparatus, an equipment front end module (EFEM) 30 and a controller 50. The charged particle-optical device 40 may be within the vacuum chamber 10. The electron-optical apparatus may comprise a charged particle-optical device 40 (also known as an electron-optical device, an electron beam device or an electron beam device) and a motorized or actuated stage.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be assessed (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the charged particle-optical device 40 by which it may be assessed. A charged particle-optical device 40 may comprise either a single beam or a multi-beam charged particle-optical apparatus.

The controller 50 is electronically connected to the charged particle-optical device 40. The controller 50 may be a processor (such as a computer) configured to control the charged particle beam assessment apparatus 100. The controller 50 may also include a processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it may be distributed over at least two of the component elements. While the present disclosure provides examples of main chamber 10 housing an electron beam assessment apparatus, it should be noted that aspects of the disclosure in their broadest sense are not limited to a chamber housing a charged particle-optical device. Rather, it is appreciated that the foregoing principles may also be applied to other apparatuses and other arrangements of apparatus that operate under the second pressure.

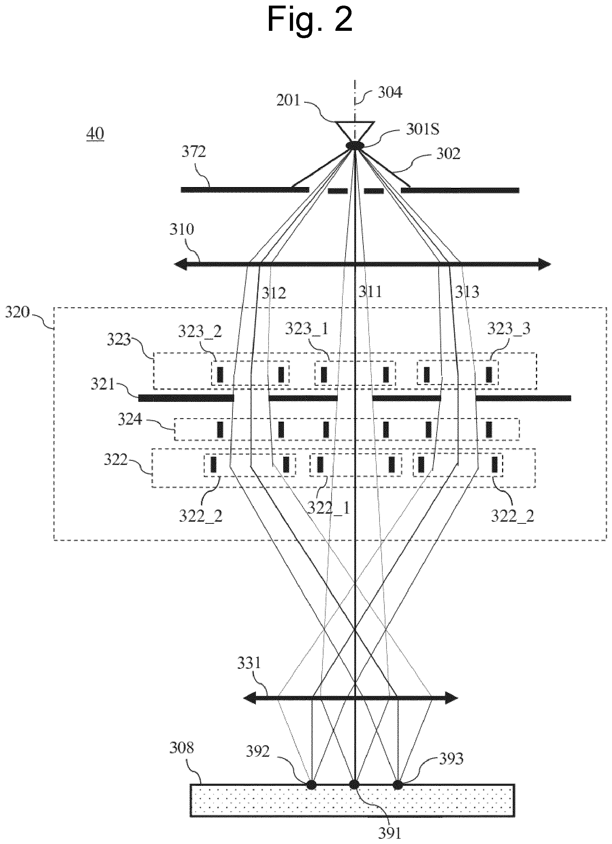

Reference is now made to **FIG. 2****,** which is a schematic diagram of an exemplary multi-beam charged particle-optical device 40 of an assessment apparatus, e.g. the assessment apparatus 100 of **FIG. 1****.** In an alternative embodiment the assessment apparatus 100 is a single-beam assessment apparatus. The charged particle-optical device 40 may comprise an electron source 201, a beam former array 372 (also known as a gun aperture plate, a coulomb aperture array or a pre-sub-beamforming aperture array), a condenser lens 310, a source converter (or micro-optical array) 320, an objective lens 331, and a target 308. In an embodiment the condenser lens 310 is magnetic. The target 308 may be supported by a support on a stage. The stage may be motorized. The stage moves so that the target 308 is scanned by the incident electrons. The electron source 201, the beam former array 372, the condenser lens 310 may be the components of an illumination apparatus comprised by the charged particle-optical device 40. The source converter 320 (also known as a source conversion unit), described in more detail below, and the objective lens 331 may be the components of a projection apparatus comprised by the charged particle-optical device 40.

The electron source 201, the beam former array 372, the condenser lens 310, the source converter 320, and the objective lens 331 are aligned with a primary electron-optical axis 304 of the charged particle-optical device 40. The electron source 201 may generate a primary beam 302 generally along the electron-optical axis 304 and with a source crossover (virtual or real) 301S. During operation, the electron source 201 is configured to emit electrons. The electrons are extracted or accelerated by an extractor and/or an anode to form the primary beam 302.

The beam former array 372 cuts the peripheral electrons of primary electron beam 302 to reduce a consequential Coulomb effect. The primary-electron beam 302 may be trimmed into a specified number of sub-beams, such as three sub-beams 311, 312 and 313, by the beam former array 372. It should be understood that the description is intended to apply to a charged particle-optical device 40 with any number of sub-beams such as one, two or more than three. The beam former array 372, in operation, is configured to block off peripheral electrons to reduce the Coulomb effect.

The source converter 320 is configured to convert the beam (including sub-beams if present) transmitted by the beam former array 372 into the sub-beams that are projected towards the target 308. In an embodiment the source converter is a unit. Alternatively, the term source converter may be used simply as a collective term for the group of components that form the beamlets from the sub-beams.

As shown in **FIG. 2****,** in an embodiment the charged particle-optical device 40 comprises a beam-limiting aperture array 321 with an aperture pattern (i.e. apertures arranged in a formation) configured to define the outer dimensions of the beamlets (or sub-beams) projected towards the target 308. In an embodiment the beam-limiting aperture array 321 is part of the source converter 320. In an alternative embodiment the beam-limiting aperture array 321 is part of the system upbeam of the main device. In an embodiment, the beam-limiting aperture array 321 divides one or more of the sub-beams 311, 312, 313 into beamlets such that the number of beamlets projected towards the target 308 is greater than the number of sub-beams transmitted through the beam former array 372. In an alternative embodiment, the beam-limiting aperture array 321 keeps the number of the sub-beams incident on the beam-limiting aperture array 321, in which case the number of sub-beams may equal the number of beamlets projected towards the target 308.

As shown in **FIG. 2****,** in an embodiment the charged particle-optical device 40 comprises a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams 311, 312, and 313 onto the beam-limiting aperture array 321.

The charged particle-optical device 40 may also include an image-forming element array 322 with image-forming deflectors 322_1, 322_2, and 322_3. There is a respective deflector 322_1, 322_2, and 322_3 associated with the path of each beamlet. The deflectors 322_1, 322_2, and 322_3 are configured to deflect the paths of the beamlets towards the electron-optical axis 304. The deflected beamlets form virtual images (not shown) of source crossover 301S. In the current embodiment, these virtual images are projected onto the target 308 by the objective lens 331 and form probe spots 391, 392, 393 thereon. The charged particle-optical device 40 may also include an aberration compensator array 324 configured to compensate aberrations that may be present in each of the sub-beams. In an embodiment the aberration compensator array 324 comprises a lens configured to operate on a respective beamlet. The lens may take the form or an array of lenses. The lenses in the array may operate on a different beamlet of the multi-beam. The aberration compensator array 324 may, for example, include a field curvature compensator array (not shown) for example with micro-lenses. The field curvature compensator and micro-lenses may, for example, be configured to compensate the individual sub-beams for field curvature aberrations evident in the probe spots, 391, 392, and 393. The aberration compensator array 324 may include an astigmatism compensator array (not shown) with micro-stigmators. The micro-stigmators may, for example, be controlled to operate on the sub-beams to compensate astigmatism aberrations that are otherwise present in the probe spots, 391, 392, and 393.

The image-forming element array 322, the aberration compensator array 324, and the pre-bending deflector array 323 may comprise multiple layers of sub-beam manipulating devices, some of which may be in the form of arrays, for example: micro-deflectors, micro-lenses, or micro-stigmators. Beam paths may be manipulated rotationally. Rotational corrections may be applied by a magnetic lens. Rotational corrections may additionally, or alternatively, be achieved by an existing magnetic lens such as the condenser lens arrangement.

The objective lens 331 focuses the beamlets onto the surface of the target 308, i.e., it projects the three virtual images onto the target surface. The three images formed by three sub-beams 311 to 313 on the target surface form three probe spots 391, 392 and 393 thereon. In an embodiment the deflection angles of sub-beams 311 to 313 are adjusted to pass through or approach the front focal point of objective lens 331 to reduce or limit the off-axis aberrations of three probe spots 391 to 393. In an arrangement the objective lens 331 is magnetic. Although three beamlets are mentioned, this is by way of example only. There may be any number of beamlets.

In an embodiment a beam separator (not shown) is provided. The beam separator may be downbeam of the source converter 320. The beam separator may be, for example, a Wien filter comprising an electrostatic dipole field and a magnetic dipole field. The beam separator may be upbeam of the objective lens 331. In operation, the beam separator may be configured to exert an electrostatic force by electrostatic dipole field on individual electrons of sub-beams. In an embodiment, the electrostatic force is equal in magnitude but opposite in direction to the magnetic force exerted by the magnetic dipole field of beam separator on the individual primary electrons of the sub-beams. The sub-beams may therefore pass at least substantially straight through the beam separator with at least substantially zero deflection angles. The direction of the magnetic force depends on the direction of motion of the electrons while the direction of the electrostatic force does not depend on the direction of motion of the electrons. So because the secondary electrons and backscattered electrons (or signal electrons) generally move in an opposite direction compared to the primary electrons, the magnetic force exerted on the secondary electrons and backscattered electrons (or signal particles) will no longer cancel the electrostatic force and as a result the secondary electrons and backscattered electrons moving through the beam separator will be deflected away from the electron-optical axis 304.

In an embodiment a secondary device (not shown) is provided comprising detection elements for detecting corresponding secondary charged particle beams. On incidence of secondary beams with the detection elements, the elements may generate corresponding intensity signal outputs. The outputs may be directed to an image processing system (e.g., controller 50). Each detection element may comprise an array which may be in the form of a grid. The array may have one or more pixels; each pixel may correspond to an element of the array. The intensity signal output of a detection element may be a sum of signals generated by all the pixels within the detection element.

In an embodiment a secondary projection apparatus and its associated electron detection device (not shown) are provided. The secondary projection apparatus and its associated electron detection device may be aligned with a secondary electron-optical axis of the secondary device. In an embodiment the beam separator is arranged to deflect the path of the secondary electron beams towards the secondary projection apparatus. The secondary projection apparatus subsequently focuses the path of secondary electron beams onto a plurality of detection regions of the electron detection device. The secondary projection apparatus and its associated electron detection device may register and generate an image of the target 308 using the secondary electrons or backscattered electrons (or signal particles).

Such a Wien filter, a secondary device and/or a secondary projection apparatus may be provided in a single beam assessment apparatus. Additionally and/or alternatively a detection device may be present downbeam of the objective lens, for example facing the sample during operation. In an alternative arrangement a detector device is position along the path of the charged particle beam towards the sample. Such an arrangement does not have a Wien filter, a secondary device and a secondary projection apparatus. The detection device may be positioned at one or more positions along the path of the charged particle beam path towards the sample, such as facing the sample during operation, for example around the path of the charged particle beam. Such a detector device may have an aperture and may be annular. The different detector devices may be positioned along the path of the charged particle to detect signal particles having different characteristics. The electron-optical elements along the path of the charged particle beam, which may include one or more electrostatic plates with an aperture for the path of the charged particle beam, may be arranged and controlled to focus the signal particles of different respective characteristics to a respective detector device at different positions along the path of charged particle beams. Such electrostatic plates may be arranged in series of two or more adjoining plates along the path of the charged particle beam.

Any element or collection of elements may be replaceable or field replaceable within the charged particle-optical device. The one or more electron-optical components in the charged particle-optical device, especially those that operate on sub-beams or generate sub-beams, such as aperture arrays and manipulator arrays may comprise one or more plates each of which may be an electrode or may comprise one or more electrodes per aperture of the array. Such a plate may be manufactured using processing suitable for manufacturing microelectromechanical systems (MEMS); such a charged particle-optical component or device may be referred to as a MEMS. MEMS are miniaturized mechanical and electromechanical elements that are made using microfabrication techniques. The pre-bending deflector array 323 may be a MEMS. In an embodiment the charged particle-optical device 40 comprises apertures, lenses and deflectors which may be formed as MEMS. In an embodiment, the manipulators such as the lenses and deflectors 322_1, 322_2, and 322_3 are controllable, passively, actively, as a whole array, individually or in groups within an array, so as to control the beamlets of charged particles projected towards the target 308.

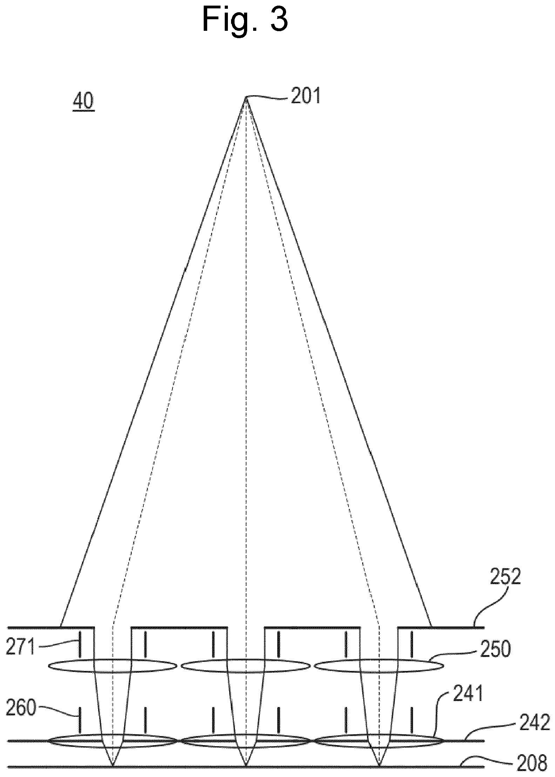

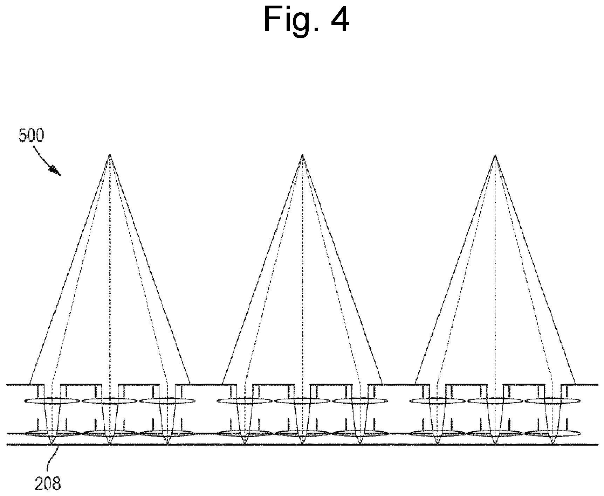

In an embodiment the charged particle-optical device 40 may comprise alternative and/or additional components on the charged particle path, such as lenses and other components some of which have been described earlier with reference to **FIG. 1** and **2****.** Examples of such arrangements are shown in **FIG. 3** and **4** which are described in further detail later. A detector is provided to detect charged particles emitted by the sample. The detector may be integrated into the objective lens. The detector may be on the bottom surface of the objective lens so as to face a sample in use. The detector may comprise an array, for example of detector elements, which may correspond to the array of the beamlets of the multi-beam arrangement. The detectors (or detector elements) in the detector array may generate detection signals that may be associated with the pixels of a generated image. The condenser lenses, objective lenses and/or detector may be formed as MEMS or CMOS devices.

**FIG. 3** is a schematic diagram of another design of an exemplary charged particle-optical device 40. The charged particle-optical device 40 may comprise a source 201 and one or more electron-optical assemblies. Alternatively, the electron-optical apparatus that comprises the charged particle-optical device 40 may comprise the source 201. The charged particle-optical device 40 may comprise an upper beam limiter 252, a collimator element array 271, a control lens array 250, a scan deflector array 260, an objective lens array 241, a beam shaping limiter 242 and a detector array. The source 201 provides a beam of charged particles (e.g. electrons).

The upper beam limiter 252 defines an array of beam-limiting apertures. The upper beam limiter 252 may be referred to as an upper beam-limiting aperture array or upbeam beam-limiting aperture array. The upper beam limiter 252 may comprise a plate (which may be a plate-like body) having a plurality of apertures. The upper beam limiter 252 forms the sub-beams from the beam of charged particles emitted by the source 201. Portions of the beam other than those contributing to forming the sub-beams may be blocked (e.g. absorbed) by the upper beam limiter 252 so as not to interfere with the sub-beams down-beam. The upper beam limiter 252 may be referred to as a sub-beam defining aperture array.

The collimator element array 271 is provided downbeam of the upper beam limiter 252. Each collimator element collimates a respective sub-beam. The collimator element array 271 may be formed using MEMS manufacturing techniques so as to be spatially compact. In some embodiments, exemplified in **FIG. 3****,** the collimator element array 271 is the first deflecting or focusing electron-optical array element in the beam path downbeam of the source 201. In another arrangement, the collimator may take the form, wholly or partially, of a macro-collimator. Such a macro-collimator may be upbeam of the upper beam limiter 252 so it operates on the beam from the source before generation of the multi-beam. A magnetic lens may be used as the macro-collimator.

Down-beam of the collimator element array there is the control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit).

As mentioned, the control lens array 250 is associated with the objective lens array 241. As described above, the control lens array 250 may be considered as providing electrodes additional to the electrodes 242, 243 of the objective lens array 241 for example as part of an objective lens array assembly. The additional electrodes of the control lens array 250 allow further degrees of freedom for controlling the electron-optical parameters of the sub-beams. In an embodiment the control lens array 250 may be considered to be additional electrodes of the objective lens array 241 enabling additional functionality of the respective objective lenses of the objective lens array 241. In an arrangement such electrodes may be considered part of the objective lens array providing additional functionality to the objective lenses of the objective lens array 241. In such an arrangement, the control lens is considered to be part of the corresponding objective lens, even to the extent that the control lens is only referred to as being a part of the objective lens for example in terms of providing one more extra degrees of freedom to the objective lens. Although the control lens array 241 may be indistinct from and part of the objective lens array 250, in this description the control lens array 250 is considered to be distinct and separate from the objective lens array 241.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple plates with apertures.

The scan-deflector array 260 comprising a plurality of scan deflectors may be provided. The scan-deflector array 260 may be formed using MEMS manufacturing techniques. Each scan deflector scans a respective sub-beam over the sample 208. In an embodiment, the scanning deflectors described in EP2425444, which document is hereby incorporated by reference in its entirety specifically in relation to scan deflectors, may be used to implement the scan-deflector array 260.

The objective lens array 241 comprising a plurality of objective lenses is provided to direct the sub-beams onto the sample 208. Each objective lens comprises at least two electrodes (e.g. two or three electrodes) connected to respective potential sources.

The objective lens array may form part of an objective lens array assembly along with any or all of the scan-deflector array 260, control lens array 250 and collimator element array 271. The objective lens array assembly may further comprise the beam shaping limiter 242. The beam shaping limiter 242 defines an array of beam-limiting apertures. The beam shaping limiter 242 may be referred to as a lower beam limiter, lower beam-limiting aperture array or final beam-limiting aperture array.

In an arrangement, the beam shaping limiter 242 is structurally integrated with an electrode 302 of the objective lens array 241. Desirably, the beam shaping limiter 242 is positioned in a region of low electrostatic field strength. Each of the beam-limiting apertures is aligned with a corresponding objective lens in the objective lens array 241.

In an embodiment, the charged particle-optical device 40 is configured to control the objective lens array assembly (e.g. by controlling potentials applied to electrodes of the control lens array 250) so that a focal length of the control lenses is larger than a separation between the control lens array 250 and the objective lens array 241. The control lens array 250 and objective lens array 241 may thus be positioned relatively close together, with a focusing action from the control lens array 250 that is too weak to form an intermediate focus between the control lens array 250 and objective lens array 241. The control lens array and the objective lens array operate together to define a combined focal length to the same surface. Combined operation without an intermediate focus may reduce the risk of aberrations. In other embodiments, the objective lens array assembly may be configured to form an intermediate focus between the control lens array 250 and the objective lens array 241.

An electric power source may be provided to apply respective potentials to electrodes of the control lenses of the control lens array 250 and the objective lenses of the objective lens array 241.

The detector array (not shown) is provided to detect charged particles emitted from the sample 208. The detected charged particles may include any of the charged particles (e.g. signal particles) detected by a scanning electron microscope, including secondary (e.g. emitted) and/or backscattered electrons from the sample 208. The detector may be an array providing the surface of the charged particle-optical device facing the sample 208, e.g. the bottom surface of the charged particle-optical device. Alternatively (or additionally) the detector array be upbeam of the bottom surface or example in or upbeam of the objective lens array or the control lens array. The elements of the detector array may correspond to the beamlets of the multi-beam arrangement. The signal generated by detection of an electron by an element of the array may be transmitted to a processor for generation of an image. The signal may correspond to a pixel of an image.

In other embodiments both a macro scan deflector and the scan-deflector array 260 are provided. In such an arrangement, the scanning of the sub-beams over the sample surface may be achieved by controlling the macro scan deflector and the scan-deflector array 260 together, preferably in synchronization.

In an embodiment, as exemplified in **FIG. 4****,** a charged particle-optical device array 500 is provided. The array 500 may comprise a plurality of any of the charged particle-optical devices described herein. Each of the charged particle-optical devices focuses respective multi-beams simultaneously onto different regions of the same sample.

Any number of charged particle-optical devices may be used in the array 500. Each charged particle-optical device in the array 500 may be configured in any of the ways described herein when referring to a single charged particle-optical device, for example as described above, especially with respect to the embodiment shown and described in reference to **FIG. 3****.** Details of such an arrangement is described in EPA 20184161.6 filed 6 July 2020 which, with respect to how the objective lens is incorporated and adapted for use in the multi-device arrangement is hereby incorporated by reference.

In the example of **FIG. 4** the array 500 comprises a plurality of charged particle-optical devices of the type described above with reference to **FIG. 3****.**

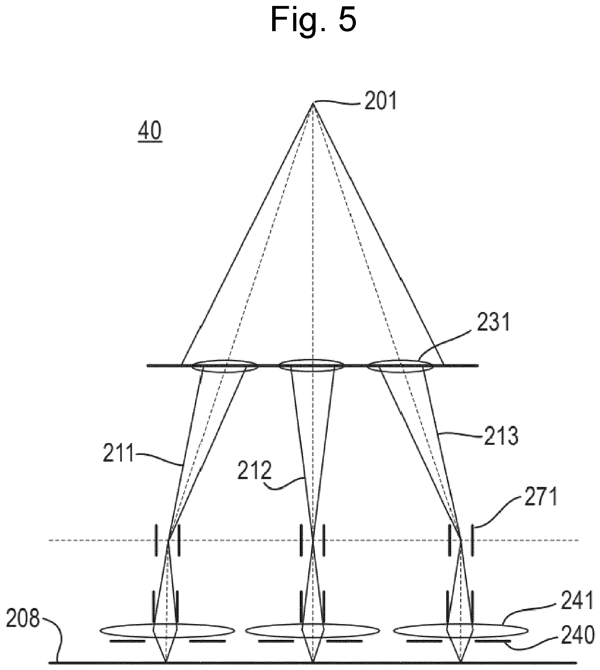

An alternative design of multi-beam charged particle-optical device may have the same features as described with respect to **FIG. 3** except as described below and illustrated in **FIG. 5****.** The alternative design of multi-beam charged particle-optical device may comprise a condenser lens array 231 upbeam of the object lens array arrangement 241, as disclosed in EP application 20158804.3 filed on 21 February 2020 which is hereby incorporated by reference so far as the description of the multi-beam device with a collimator and its components.

In an embodiment of the arrangement shown in and described with reference to **FIG. 5****,** the detector may be located in similar locations in the charged particle-optical device 40 as described with reference to and as shown in the charged particle-optical device of **FIG. 3****.** The detector 240 may be integrated into the objective lens array 241 and the control lens array 250 (when present as it is not depicted in **FIG. 5**). The detector may have more than one detector at different positions along the paths of the sub-beams of the multibeam.

A charged particle-optical device array may have multiple multi-beam devices of this design as described with reference to the multi-beam device of **FIG. 3** as shown in **FIG. 4****.** The multiple multi-beam devices may be arranged in an array of multi-beam devices. Such an arrangement is shown and described in EP Application 20158732.6 filed on 21 February 2020 which is hereby incorporated by reference with respect to the multi-device arrangement of a multi-beam apparatus featuring the design of multi-beam device disclosed with a collimator at, or even proximate to, an intermediate focus. A further alternative design of multi-beam apparatus comprises multiple single beam devices.

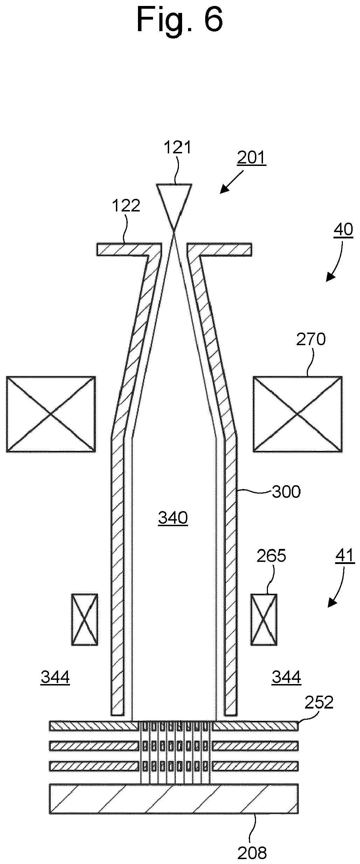

As shown in **FIG. 6****,** in an embodiment the charged particle-optical device 40 comprises a beam tube 300 (which may also be called a tube, liner tube, or booster tube). In an embodiment the beam tube 300 is arranged to surround the multi-beam path. The beam tube 300 surrounds the paths of charged particles. The charged particles may be a source beam emitted from the source 121 towards a sample. The charged particles may be of a plurality of beams of the multibeam. The beam tube 300 may surround the source beam path or the multi-beam path for example when viewed along the primary axis of the charged particle-optical device 40, i.e. in the direction of the charged particle beam. In an embodiment the beam tube 300 is configured to surround only part of the charged particle path, i.e. part of the charged particle path along the length of the charged particle path for example a length along part of the charged particle path. For example, as shown in **FIG. 6****,** in an embodiment the beam tube 300 surrounds the part of the multi-beam path from the source 201 to just above the sub-beam forming array 252. In other embodiments, the beam tube 300 surrounds different portions, e.g. lengths, of the multi-beam path.

In an embodiment the beam tube 300 is configured to operate at a first potential difference from ground. A support may be configured to support the sample 208 at a second potential difference from ground or at ground. The first potential difference may be greater than the second potential difference and such as to accelerate the charged particles of the multi-beam towards the sample 208. Arranging for the potential difference between the sample and the immediate environment to be relatively low may reduce the possibility of electrical breakdown in the vicinity of the sample 208. This can reduce the possibility of the sample 208 being damaged. The risk of damage to components of the charged particle device 41 such as the detector 240 (which may feature delicate electronic elements) may be reduced.

As explained above and exemplified in **FIG. 6****,** the electron source 201 may comprise a cathode 121 and an anode 122 (which may also be called an extractor or an extractor electrode). The cathode 121 and the anode 122 are configured to operate with a potential difference between them. The cathode 121 is configured to emit the charged particle beam. The anode 122 is configured to accelerate the charged particle beam towards the sample 208. Note, this source arrangement is a simplified arrangement. The source 201 may have a different arrangement and other electrodes, so long as the source 201 has a most down-beam source electrode, which is here referred to as the anode 122.

As shown in **FIG. 6****,** in an embodiment the beam tube 300 is electrically connected to the anode 122. By electrically connecting the beam tube 300 to the anode 122, there is no electric field formed between the source 201 and the beam tube 300. Any unwanted lensing effect up-beam of the beam tube 300 is avoided. The beam tube 300 may be formed together with the anode 122. The beam tube 300 and the anode 122 may be integral. Alternatively, the beam tube 300 may be separated from the source 201. The beam tube 300 may be distanced along the axial direction from the anode 122.

As shown in **FIG. 6****,** in an embodiment at least part of the charged particle device 41 is down-beam of the most down-beam end of the beam tube 300. For example, the sub-beam forming array 252, the control lens array 250, the objective lens array 241 and the beam shaping aperture array 262 may be provided down-beam of the beam tube 300. In an embodiment, the part of the charged particle device 41 down-beam from the beam tube 300 may be configured to decelerate the charged particle beam. The part of the charged particle device 41 down-beam from the beam tube 300 may be referred to as a charged particle optical element.

In an embodiment, the charged particle-optical device 40 is configured such that the charged particle beam passes through the charged particle-optical device 40 without undesirable lensing effects being applied to the beam. The down-beam end of the beam tube 300 may be configured to be in a region that has a small electric field or no electric field. This can help reduce or avoid any lensing effect on the charged particle beam that could be caused by an electric field between the beam tube 300 and any parts of the charged particle device 41 down-beam of the beam tube 300. In a different arrangement, which may be less desirable, there may be a controlled potential difference between the down-beam end of the beam tub 300 and a surface of an adjacent part of the charged particle optical device 41 for lensing the paths of the charged particles towards the sample 208.

As shown in **FIG. 6****,** in an embodiment the beam tube 300 is spaced apart from the part of the charged particle device 41 down-beam of the beam tube 300. The separation may make it easier to manufacture the charged particle apparatus (by easing tolerances) and/or to replace part or all of the charged particle device 41. In an embodiment the separation is at most 1mm. Any electric field between the beam tube 300 and any part of the charged particle device 41 down-beam of the beam tube 300 may be confined to a small distance. This arrangement may help to reduce or even prevent the effect of any electric field between the beam tube 300 and a part of the charged particle device down-beam of the beam tube 300. In an alternative arrangement, the spacing apart of the beam tube 300 and a surface of the charged particle device 41 down-beam of the beam tube 300 may enable a lensing operation on the charged particles projected towards a sample position.

In an alternative embodiment the beam tube 300 is electrically connected to the part of the charged particle device 41 that is down beam of the beam tube 300. For example, the beam tube 300 may be structurally connected to and/or integral with the associated plate, for example the sub-beam forming array 252.

In the example of **FIG. 6****,** a macro collimator 270 comprising a magnetic component is provided, for example as part the charged particle device 41. The magnetic component can influence trajectories of charged particles within the beam tube 300 while being located outside of the beam tube 300.

In an alternative embodiment the macro collimator 270 comprises an electrostatic component. Such an electrostatic component may be affected by the beam tube 300, for example its shielding of electrostatic fields external to the beam tube 300. In an embodiment the electrostatic component of the macro collimator 270 is located within the beam tube 300 (not shown) or between lengths or sections of the beam tube (see EP Application 21199203.7 filed 27 September 2021, hereby incorporated by reference at least so far as designs comprising electron-optical elements and a beam tube and its sections).

In an embodiment the charged particle device 41 comprises a macro scan deflector 265. The macro scan deflector 265 is configured to deflect respective portions of the charged particle beam. The respective portions correspond to different sub-beams further down-beam. Deflection of the portions by the macro scan deflector 265 thus causes deflection of the respective sub-beams of charged particles, in the multi-beam, to be scanned relative to, for example over, the sample 208. As shown in **FIG. 6** in an embodiment the macro scan deflector 265 is up-beam of the down-beam end of the beam tube 300.

As shown in **FIG. 6****,** in an embodiment the macro scan deflector 265 comprises a magnetic deflector. The macro scan deflector 265 may be located outside of the beam tube 300.

In an alternative embodiment the macro-scan deflector is electrostatic. Such an electrostatic scan deflector may be placed between sections or lengths of the beam tube 300. The electrostatic scan deflector may be spaced away from the sections of the beam tube 300 up beam and down beam of the scan deflector 300.

Additionally or alternatively a scan deflector comprising an array of deflectors may be provided instead of a macro scan deflector. Such an array of deflectors is provided within the charged particle device 41 as an array of scan deflectors 260 as depicted in **FIG. 3****.** Such an array of scan deflectors may be associated with an objective lens array, for example in which a deflector of the array is associated with each beam of the multi-beam.

In the embodiment shown in **FIG. 6****,** the beam tube 300 extends continuously from a position close to the sub-beam forming array 252 to the source 122. When the beam tube 300 is metallic (or is coated with a metallic material) this will shield the interior of the beam tube 300 from electrostatic fields generated outside of the beam tube 300. As explained above, elements may be provided for manipulating charged particle trajectories within the beam tube 300 either via magnetic fields generated outside of the beam tube 300 or via magnetic or electrostatic fields generated within the beam tube 300. A further possibility, not shown, is to provide gaps in the beam tube 300 to allow electric fields generated outside of the beam tube to influence charged particle trajectories within the beam tube 300.

The charged particle-optical device 40 may be a component of an assessment apparatus (e.g. for inspection, metrology, metro-inspection or any other type of assessment) or part of an e-beam lithography apparatus or other type of charged particle induced sample patterning apparatus. The multi-beam charged particle apparatus may be used in a number of different applications that include electron microscopy in general, not just scanning electron microscopy, and lithography.

As mentioned in the introductory part of the description, high electric fields can trigger discharge events by electric breakdown, potentially leading to component damage. For example, where a detector array is positioned close to a sample 208 and maintained at a different potential, there may be a high electric field between the detector array and the sample 208. The potential difference may be needed to promote collection efficiency of signal particles by the detector array. The close spacing between the detector array and the sample 208 may be needed to prevent excessive cross-talk between different detector elements of the detector array. Discharge events due to the resulting high electric field in the region between such a detector array and the sample 208 can damage sensitive elements of the detector array, such as sensitive components within an integrated circuit forming the detector array or associated with operation of the detector array. Discharge events may additionally or alternatively be triggered by electric fields upbeam of the detector array. Discharge events may be generated in other parts of the charged particle-optical device 40 and may additionally or alternatively lead to damage to components located elsewhere in the charged particle-optical device 40.

In an embodiment, it is possible to reduce the risk of discharge damage by using discharge damage protection elements such as diodes. However, such discharge damage protection can increase system complexity and/or reduce noise performance (for example reduce the ratio of detection signal to noise). For example, the inventors have found that discharge damage protection is undesirable in the detector array because of the disadvantageous impact on noise performance arising due to the capacitance of diodes used to provide the discharge damage protection; for example increasing the difficulty of distinguishing detection signals from the noise for meaningful assessment of a sample.

Embodiments described particularly below aim to at least partially address one or more of these issues. In some of these embodiments, discharge damage protection is provided by configuring an electrical environment of sensitive circuitry, for example on-chip circuitry associated with a detector array, such that voltages across and current through sensitive elements does not exceed critical values even in the presence of discharge events. This may be achieved by providing a low impedance connection between sensitive elements (e.g., the detector array) and at a stable potential. Some of the embodiments described below achieve this by connecting sensitive elements to a ground potential using a low impedance connection.

In an embodiment, a charged particle apparatus is provided for projecting a multi-beam of charged particles toward a sample 208. The charged particle apparatus comprises a sample support to support a sample 208. The sample support may comprise a motorized or actuated stage and/or take any of the forms described above with reference to **FIG. 1** and/or **FIG. 2****.** In an embodiment, the charged particle apparatus comprises a charged particle-optical device 40. The charged particle-optical device 40 is configured to project beams of a multi-beam of the charged particles along a plurality of paths toward the sample 208. The charged particle-optical device 40 comprises a plurality of charged particle-optical elements 60 that define a lens such as an objective lens and/or a control lens in which are defined a plurality of apertures along the paths of the beams. The charged particle-optical elements 60 may be planar elements substantially orthogonal to the paths of the beams.

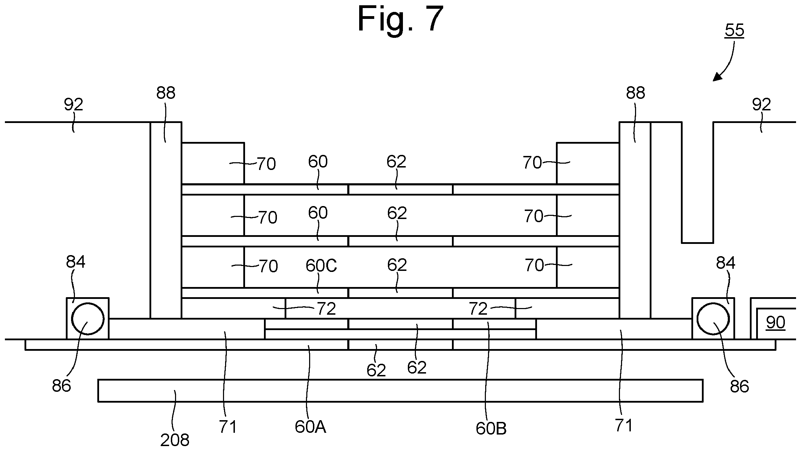

In an embodiment, the plurality of charged particle-optical elements 60 are provided in a charged particle-optical module 55 as exemplified in **FIG. 7****.** In the orientation shown in **FIG. 7****,** the plurality of paths may have a direction corresponding to a charged particle-optical axis of the charged particle-optical device 40. In the depicted orientation, the plurality of paths may be substantially vertical in the plane of the page; however this orientation is a matter of convenience for the present description. The orientation of the charged particle-optical module 55 is any orientation which may be desirably selected. The apertures are provided in beam areas 62 of the charged particle-optical elements 60. As shown in **FIG. 7****,** the beam areas 62 may be located generally centrally and/or aligned with each other when viewed in a direction parallel to the paths of the beams and/or orthogonally to planes of the charged particle-optical elements. The lens may be the objective lens array 241 and/or the control lens array 250. The plurality of charged particle-optical elements 60 may additionally or alternatively define the condenser lens array 231 and/or the collimator array 271 and/or an individual beam corrector and/or a deflector and/or a Wien filter array. The charged particle-optical device 40 may take any of the forms described above with reference to **FIG. 1** to **6** or other forms.

As shown in **FIG. 7****,** in an embodiment the charged particle-optical module 55 comprises one or more spacers 70-72. The spacers 70-72 are configured to mechanically support the charged particle-optical elements 60. Some or all of the spacers 70-72 may be configured to electrically isolate at least a subset of the charged particle-optical elements 60 from each other.

In an embodiment the charged particle-optical module 55 is field replaceable. The charged particle-optical module 55 may be removed from and/or inserted into the charged particle-optical device 40 without requiring any substantial dismantling of other parts of the charged particle-optical device 40. That is the charged particle-optical module 55 may be removable from and/or insertable into the charged particle-optical device 40.

In an embodiment, at least two of the charged particle-optical elements 60 are configured to be set at different potentials. In an embodiment, at least one of the charged particle-optical elements 60 is set at ground potential. In some embodiments, the at least one of the charged particle-optical elements set at ground potential comprises an electrode of the objective lens. Alternatively or additionally, the at least one of the charged particle-optical elements set at ground potential comprises a detector substrate comprising a detector array configured to detect signal particles emitted from the sample 208. As described in further detail below, the detector array may comprise an array of detector elements and/or an integrated circuit in the detector substrate. The detector array may take any of the forms described above with reference to **FIG. 3** to **5** particularly. The detector array may form part of the detector 240.

Setting at least one of the charged particle-optical elements 60 at ground potential facilitates provision of a low impedance electrical path from that charged particle-optical elements 60 to a stable electrical potential. This may reduce the risk of damage to the charged particle-optical element 60 from electric discharge events. Alternatively or additionally, setting the at least one of the charged particle-optical elements 60 at ground potential may provide electrostatic shielding that reduces the risk of damage to fragile components, such as a detector array, from electric fields on an opposite side of the shielding.

In an embodiment, at least two of the charged particle-optical elements 60 are configured to face each other. In an embodiment, one of the at least two charged particle-optical elements 60 that are configured to face each other is a facing electrode 60B. The facing electrode 60B may be an electrode of the objective lens. The facing electrode 60B defines a continuous conductive surface configured to define multiple apertures in the facing electrode 60B. Each aperture may surround the path of a respective beam of the multi-beam. The continuous conductive surface electrostatically shields a charged particle-optical element 60A, which may be referred to as a shielded charged particle-optical element 60A, that the facing electrode 60B faces. The shielded charged particle-optical element 60A is shielded from electric fields on an opposite side of the facing electrode 60B. The shielded charged particle-optical element 60A may thus be shielded from electric fields upbeam of the facing electrode 60B. Shielding the charged particle-optical element 60A from the electric fields reduces a risk of, or prevents, damage to the shielded charged particle-optical element 60A from the electric fields. The facing electrode 60B may be set at ground potential.

In an embodiment, the charged particle apparatus comprises a first spacer element 71. The first spacer element 71 may be electrically connected to at least one of the charged particle-optical elements 60. In an embodiment, the first spacer element 71 is electrically connected to at least the shielded charged particle-optical element 60A. In an embodiment, the first spacer element 71 is set to ground potential. The electrical connection from the first spacer element 71 to the shielded charged particle-optical element 60A may thus set the shielded charged particle-optical element 60A to ground potential.

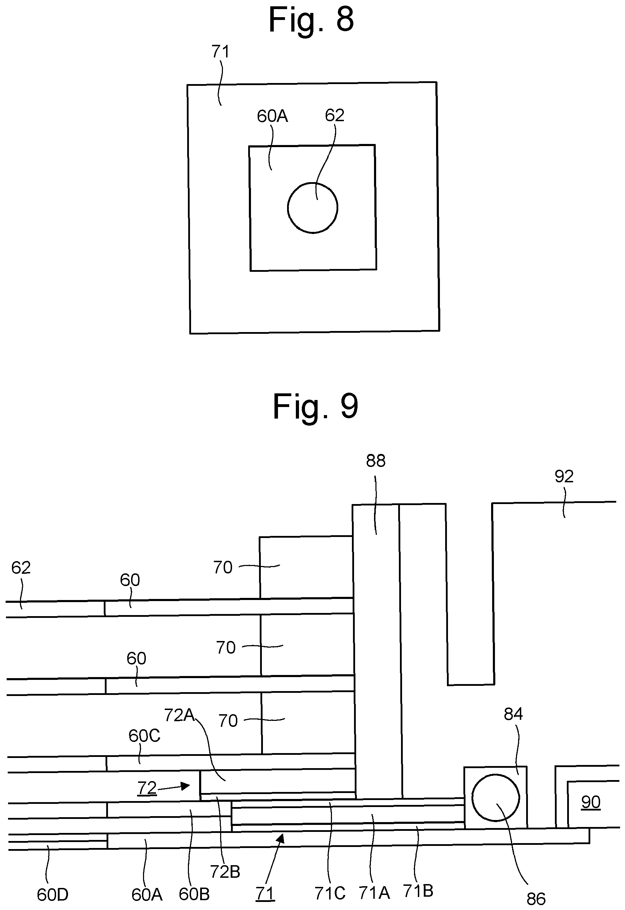

In an embodiment, the shielded charged particle-optical element 60A is connected to the facing electrode 60B via the first spacer element 71. In an embodiment, the first spacer element 71 defines at least one conductive body forming a planar shape. The first spacer element 71 may be referred to as a conductive spacer. An example shape of the first spacer element 71 is depicted in **FIG. 8. FIG. 8** is a sectional view through the first spacer element 71 of the charged particle-optical module 55 of **FIG. 7****,** viewed along an axis parallel with the paths of the beams of the multi-beam. In an embodiment, the planar shape is a closed loop, as shown in **FIG. 7****.** The closed loop defines an opening. In the example of **FIG. 7** a portion of the shielded charged particle-optical element 60A and the beam area 62 of the shielded charged particle-optical element 60A are visible through the opening. The closed loop may take any shape. The closed loop may be square or rectangular as exemplified in **FIG. 7** or may be rounded, for example annular (i.e., forming an annulus, for example a circular, elliptical, or oval annulus). The planar shape is configured to be positioned (e.g., is positioned) around the plurality of paths of the beams of the multi-beam. The planar shape may surround the plurality of paths of the beams of the multi-beam. When the planar shape is a closed loop, the paths of the beams of the multi-beam may pass through the opening of the closed loop. In an embodiment, the conductive body is set to ground potential.

**FIG. 9** depicts a magnified view of a portion of the charged particle-optical module 55 of **FIG. 7****.** In an embodiment, as exemplified in **FIG. 9****,** the at least one conductive body comprises a conductive layer (e.g., coating) 71B, 71C on one or both sides of the first spacer element 71. In the example of **FIG.9****,** the conductive layer 71B, 71C is provided on both sides of the first spacer element 71. Each conductive layer 71B, 71C may comprise a layer of metal for example. In an embodiment, the conductive layer 71B, 71C comprises chrome. In an embodiment, the at least one conductive body comprises a doped semiconductor body 71A (e.g., a body comprising doped silicon). The doped semiconductor body 71A may be provided in addition to or instead of the conductive coating or conductive layers 71B, 71C. Doping a semiconductor provides charge carriers that enhance electrical conductivity.

In an embodiment, as exemplified in **FIG. 9****,** the first spacer element 71 contacts the facing electrode 60B on a peripheral minor surface (e.g., a radially outwardly facing surface) of the facing electrode 60B. Alternatively or additionally, the first spacer element 71 may contact a major surface of the facing electrode 60B on a side of the facing electrode 60B closest to the sample 208 (e.g., the side facing downwards in the orientation of **FIG. 9****).** Alternatively, the first spacer element 71 may be spaced apart from the facing electrode 60B. Since the module 55 is in vacuum, there may be a vacuum between the facing electrode 60B and the shielded electron-optical element 60A and between the facing electrode 60B and the first spacer element 71. This may be desirable to thermally isolate the first spacer element 71 from the facing electrode 60B. Vacuum may function as a thermal isolator. Thermally isolating the first spacer element 71 from the facing electrode 60B reduces flow of heat between the facing electrode 60B and elements in thermal contact with the first spacer element 71 such as the shielded electron-optical element 60A. This may be desirable where the shielded electron-optical element 60A generates heat in use and it is desired to prevent this heat from causing an excessive rise in temperature of the facing electrode 60B. In an embodiment, the first spacer element 71 is configured to define an aperture. The aperture may be large enough for all of the facing electrode 60B to be within the aperture when viewed perpendicularly to a plane of the facing electrode 60B with a gap around the facing electrode 60B in most or all lateral directions, for example when viewed in an up beam direction for example from the shielded electron-optical element 60A. The aperture may have a larger dimension (e.g., in-plane width, length or diameter) than a dimension of the facing electrode 60B, such as a corresponding dimension of the facing electrode 60B, for example in a direction across (e.g., perpendicular to) paths of the beams of the multi-beam. The aperture may have a larger area than a cross-sectional area of the facing electrode 60B.

In an embodiment, as exemplified in **FIG. 9****,** the charged particle apparatus further comprises a second spacer element 72. The second spacer element 72 may be configured to support the facing electrode 60B. Alternatively or additionally, the second spacer element 72 may be configured to electrically isolate the facing electrode 60B from other components of the charged particle apparatus, such as from other charged particle-optical elements. In an embodiment, the facing electrode 60B is mechanically connected by the second spacer element 72 to an upbeam electrode upbeam of the facing electrode 60B. The second spacer element 72 may be configured to electrically isolate the facing electrode 60B from the upbeam electrode. The second spacer element 72 may thus comprise at least a layer of low electrical conductivity, such as a layer of an insulating material. Electrically isolating the facing electrode 60B from the upbeam electrode enables the facing electrode 60B and the upbeam electrode to be set at different potentials.

In an embodiment, the second spacer element 72 is configured to electrically connect the facing electrode 60B to ground potential. In an embodiment, as exemplified in **FIG. 9****,** the second spacer element 72 comprises a non-conductive body 72A and a conductive layer 72B such as a conductive coating. The layer, e.g.coating, 72B is provided on a surface closest to the sample 208. The coating 72B may contact the facing electrode 60B. Alternatively or additionally, the coating 72B may contact the first spacer element 71. The second spacer element 72 may provide an electrical path towards ground directly and/or via the first spacer element 71.

In some embodiments, at least one of the charged particle-optical elements set to the ground potential comprises electronic circuitry. For example, in some embodiments, as shown in **FIG. 9****,** at least one of the charged particle-optical elements set at ground potential comprises a detector substrate comprising a detector array 60D. The detector array 60D may comprise an array of detector elements and/or an integrated circuit (e.g., electronic circuitry) in the detector substrate. In some embodiments, the shielded charged particle-optical element 60A comprises the detector substrate. The detector substrate may thus be the charged particle-optical element closest to the sample 208. The detector substrate may be set at ground potential and/or the detector array 60D may be connected to ground potential. The detector array 60D may face the sample 208. The charged particle-optical apparatus may be configured to apply an offset potential to the sample 208 via the sample support. The offset potential may be configured to promote propagation of signal particles emitted from the sample 208 toward the detector array 60D. There may therefore be a potential difference between the sample 208 and the detector array 60D. A potential difference may additionally or alternatively be applied for reasons other than promoting propagation of signal particles toward the detector array 60D.

The integrated circuit in the detector substrate may comprises a plurality of layers. The layers may define one or more layers of circuitry. The layers may, for example, define complementary metal oxide semiconductor (CMOS) circuitry. The integrated circuit may thus comprise CMOS elements. In an embodiment, the CMOS circuitry comprises a metal layer or multiple metal layers. In an embodiment, the integrated circuit is configured to detect signal particles emitted from the sample. The metal layer may, for example, comprise one or more electrodes which may provide a surface of the CMOS circuitry on the detector substrate which in operation may face a sample 208. The metal layer may comprise detector elements configured to detect the signal particles. The detector elements may be referred to as capture electrodes. Capture electrodes are examples of sensor units for detecting signal particles. Power and control signals of the CMOS circuitry may be connected to the CMOS circuitry by electrical connections running to the integrated circuit from a region outside of the integrated circuit. The CMOS circuitry may comprise a logic layer. The logic layer may be in a different layer to the one or more electrodes. The logic layer may include amplifiers such as trans impedance amplifiers (TIAs), filters, analog-to-digital converters (ADCs) and/or readout logic.

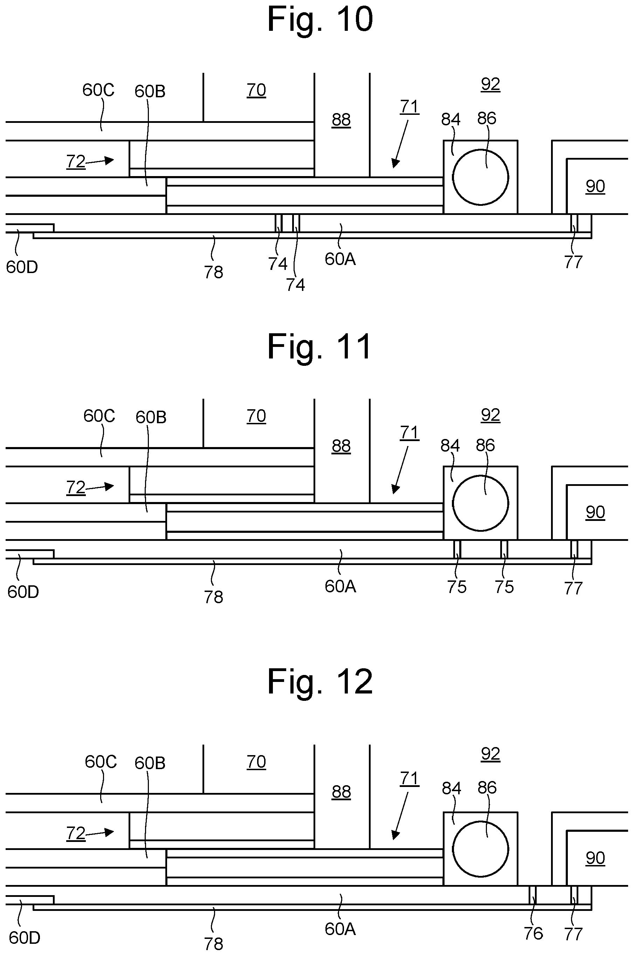

In some embodiments, the first spacer element 71 contacts the detector substrate on an opposite side of the detector substrate to the sample 208. In an embodiment, as exemplified in **FIG. 10****,** the at least one conductive body of the first spacer element 71 is in electrical connection with the detector array 60D by a via (or multiple vias) 74 through the detector substrate and/or a conductive layer 78 on a surface of the detector substrate. The conductive layer 78 may comprise a coating. As exemplified in **FIG. 10****,** the conductive layer 78 may be provided on the surface of the detector substrate facing away from the facing electrode 60B (i.e., downwards in the orientation of **FIG. 10****).** In an embodiment, the conductive body of the first spacer element 71 (e.g., conductive layer 71B and/or doped semiconductor body 71A) is in electrical connection with the integrated circuit by the via 74 and/or the conductive layer 78. The via 74 may be referred to as a through substrate via (TSV). The conductive layer 78 may take the form of and/or be referred to as a redistribution layer. In an arrangement, as shown in and described with reference to **FIG. 9** the electrical connection through the first spacer element 71 for example as a conductive spacer, or through the conductive layer 71B, may provide a grounding potential to the detector substrate 60A. In an arrangement the conductive layer 71B may extend from the first spacer element 71 towards the beam area 62, for example in a region on an opposite side of the detector substrate from the detector array 60D. The detector array 60D for example may be connected with the conductive layer 71B through a via within or proximate to the region of the detector substrate 60A corresponding to the detector array 60D. The via may connected to the detector array 60D via a portion of the conductive layer 78. In an arrangement the via directly connects the detector array 60D with the conductive layer 71B.

In some embodiments, the charged particle apparatus comprises a low impedance connection between the at least one of the charged particle-optical elements set at ground potential (e.g., the shielded charged particle-optical element 60A and/or the facing electrode 60B) and an external source of ground potential. The external source of ground potential may be a protective earth component, which may typically be easily accessible. The protective earth may comprise a structural body of a vacuum chamber for example. Providing a low impedance connection helps to reduce unwanted voltage fluctuations in the elements set to ground potential by facilitating flow of current to and from ground to stably maintain the potential at or very near to ground potential. In some embodiments, the low impedance connection is arranged to include a low resistance. In some embodiments, the low impedance connection is arranged to include a low inductance and/or low capacitance. Providing a low inductance and/or capacitance may reduce or prevent potentially harmful voltage oscillations or resonances. Voltage oscillations or resonances may be generated by electric discharge events and can lead to secondary discharges that can damage fragile components. Providing such a low impedance connection may also reduce or obviate the need for discharge protection elements in circuitry provided in the charged particle-optical module 55, such as in the detector array 60D. Discharge protection elements of lower protection capacity may be provided or discharge protection elements may be omitted. In an embodiment, the detector array 60D is configured to be free of discharge protection elements. The integrated circuit of the detector array 60D may be diode free. Reducing the capacity of, or omitting, discharge protection elements such as diodes (which may be referred to as `protective diodes') may simplify circuit design and/or improve performance by reducing or removing sources of noise or other unwanted electrical characteristics. For example, omitting a diode may advantageously improve noise performance by removing a capacitance associated with the diode, which may for example permit the detection signal to noise ratio to be greater than it otherwise would be with the presence of the diode.

In an embodiment, as depicted in **FIG. 7** and **9****-12,** the apparatus comprises a cooling channel body 84 defining a cooling channel 86 for channeling flow of a coolant. The cooling channel body 84 may be electrically conductive. The cooling channel body 84 may consist of an electrically conductive material such as a metal. The low impedance connection may comprise an electrical path through the cooling channel body 74. The cooling channel body 84 may be grounded and the at least one of the charged particle-optical elements set at ground potential may be connected to the cooling channel body 84 by a low impedance connection. For example, a low impedance connection may be provided between the detector substrate (e.g., the shielded electron-optical element 60A) and/or the detector array 60D and the cooling channel body 84. This connection may include low impedance paths through the first spacer element 71 and/or a direct connection with the cooling channel body 84. The cooling channel body 84 may for example be mounted in such a way as to have a high thermal conductance connection to the detector substrate. This connection may also have low electrical impedance. In the examples of **FIG. 7** and **9****-12,** the cooling channel body 84 is directly connected to the detector substrate. In other embodiments, the cooling channel body 84 may be indirectly connected to the detector substrate. For example, the cooling channel body 84 could be positioned with the first spacer element 71 located between the cooling channel body 84 and the detector substrate, with the cooling channel body 84 optionally in contact with the first spacer element 71. The cooling channel body 84 may be configured to act as, or be thermally and/or electrically connected to, a heat sink body (e.g., a block of material having a relatively high heat capacity and thermal conductivity). Such a heat sink body may be naturally bulky and metallic and thus serve as an efficient ground connection. Such a heat sink body may comprise of an electrically conductive material; the heat sink body may at least partly consist of metallic material. In an embodiment, a liquid management system may be provided for driving flow of the coolant through the cooling channel 86. As depicted in **FIG. 11****,** in some embodiments, a low impedance connection is provided between the detector array 60D and the cooling channel body 84 via the conductive layer 78 and one or more vias 75 (e.g., TSVs).

In an embodiment, as depicted in **FIG. 7** and **9****-12,** the apparatus comprises a support structure 92 configured to mechanically support at least the plurality of charged particle-optical elements. The support structure 92 may thus be a relatively bulky structure comprising a large proportion of electrically conductive material such as metal. The support structure 92 may thus be suitable to act as an efficient ground connection. In the examples shown an electrically insulating barrier 88 is provided between the support structure 92 and the charged particle-optical elements 60 to electrically isolate the charged particle-optical elements 60, which may need to be set to non-ground potentials, from the support structure 92. (Note the electrically insulating barrier may be thermally conductive, for example comprise a thermally conductive material). The low impedance connection may comprise an electrical path through the support structure 92. The support structure 92 may be grounded and the at least one of the charged particle-optical elements set at ground potential may be connected to the support structure 92 by a low impedance connection. For example, a low impedance connection may be provided between the detector substrate (e.g., the shielded electron-optical element 60A) and/or the detector array 60D and the support structure 92. This connection may include low impedance paths through the first spacer element 71 and/or a direct connection with the support structure 92. As depicted in **FIG. 12****,** in some embodiments a low impedance connection is provided between the detector array 60D and the support structure 92 via the conductive layer 78 and one or more vias 76 (e.g., TSVs). Additionally or alternatively, the low impedance connection may be both through the cooling channel body 84 and the support structure 92 for example in series and/or in parallel.

In some embodiments, as exemplified in **FIG. 10** to **12****,** the low impedance connection may comprise an electrical path through a via through at least one of the charged particle-optical elements (e.g., the shielded charged particle-optical element 60A) and/or an electrically conductive layer 78 facing away from another of the charged particle-optical elements (e.g., the facing electrode 60B).

In addition or alternatively to one or more of the charged particle-optical elements comprising a detector array configured to face away from all other charged particle-optical elements of the charged particle-optical device 40 set to the ground potential and/or a potential such as the ground through a connection with low impedance, there is one or more charged particle-optical elements comprising a detector array positioned in the charged particle-optical device 40 between charged particle-optical elements controllable to have potential differences relative to the charged particle-optical element comprising the detector array. The charged particle-optical element comprising the detector array may have the features of any of the embodiments described herein with reference to the detector substrate 60A. In an arrangement, such a charged particle device comprising a detector array is positioned adjacent charged-particle elements 60B that are configured to be shielding elements, for example having the same potential as the detector substrate 60A. The shielding elements may be secured by any of the embodiments of first spacer element 71 herein disclosed. In an embodiment shielding elements are both up beam and down beam of the detector substrate (for example above and below the detector substrate in an embodiment of the module 55).

In some embodiments, as exemplified in **FIG. 7** and **9****-12,** the apparatus comprises circuitry electrically connected to at least one of the charged particle-optical elements. The circuitry may be being remote from the charged particle-optical element and be connected to the ground potential. In the examples of **FIG. 7** and **9****-12,** the circuitry is provided in an electronics unit 90. The electronics unit 90 may comprise a printed circuit board (PCB). In some embodiments, as exemplified in **FIG. 10** to **12****,** the detector array 60D is electrically connected to the electronics unit 90 via the conductive layer 78 and one or more vias 77 (e.g., TSVs). In an embodiment, the electronics unit 90 is secured to the detector substrate. The electronics unit 90 may be bonded to the detector substrate. The electronics unit 90 may be secured to a major surface of the detector substrate. The electronics unit 90 may overlap a portion of the major surface of the detector substrate. The electronics unit 90 may extend laterally beyond a peripheral outer edge of the detector substrate. In an embodiment the electronics unit 90 is configured to transfer power to the detector array 60D (e.g., to an integrated circuit formed in the detector substrate). For example, the electronics unit 90 may be electrically connected to a power supply configured to supply electrical power to the integrated circuit. Additionally or alternatively, the electronics unit 90 may be configured to transfer signals to the integrated circuit. For example, in an embodiment the electronics unit 90 is configured to supply control signals to the integrated circuit. The control signals may be, for example, control signals for controlling the gain and/or offset of analog to digital converters (ADCs) comprised in the integrated circuit In an embodiment the electronics unit 90 is configured to transfer signals from the integrated circuit. For example, in an embodiment the electronics unit 90 is configured to transfer signals indicative of currents of signal particles emitted from the sample 208 and detected at the detector array 60D.

In addition or alternatively to one or more of the charged particle-optical elements comprising a detector array set to the ground potential and/or a potential such as the ground through a connection with low impedance as disclosed in any of the previously described embodiments and arrangements, one or more of the charged particle-optical elements comprises a plurality of electrodes and circuitry for actively controlling the plurality of electrodes and may be set to the ground potential and/or a potential such as the ground through a connection with a low impedance. Such circuitry for controlling the electrodes may be located external to the charged-particle-optical element such as the external electronics unit as described with reference to the detector substrate 60A. Additionally, or alternatively, the electronics may comprise circuitry within the charged particle-optical element comprising actively controllable electrodes. The electrodes and/or circuitry may take the form of CMOS circuitry and/or may have features formed using MEMS processing. Such a charged particle optical element may comprise an array of strip electrodes, for example for use in a corrector or collimator, to which the potential applied to the different electrodes may be controllable. In a different embodiment of charged particle optical element there may be an array of multipoles arranged at the different apertures in a plate of the charged particle-optical element, such as one or more electrodes around each aperture; each electrode may be individually controllable.

In some embodiments, the apparatus further comprises a plurality of position sensors. The position sensors may be or comprise level sensors. The position sensors may be capacitive sensors and/or differential sensors. The position sensors may be positioned on a surface of the charged particle-optical element (e.g., the detector substrate) that is configured to face a sample 208. The position sensors may be positioned around and away from the paths of the beams of the multi-beam. In an embodiment, the position sensors are connected to the ground potential. In an embodiment, electronics associated with the position sensors are connected to the ground potential.

Arrangements of the present disclosure may be embodied as methods.

A method of projecting charged particles toward a sample 208 is provided. The method comprises using a charged particle-optical device 40 to project beams of a multi-beam of the charged particles along a plurality of paths toward the sample 208. The charged particle-optical device 40 may take any of the forms discussed above, particularly with reference to **FIG. 7** to **12****.** The device comprises a plurality of charged particle-optical elements that define an objective lens and in which are defined a plurality of apertures along the paths of the beams. The method comprises maintaining at least two of the charged particle-optical elements at different potentials and at least one of the charged particle-optical elements at ground potential during the projecting of the beams toward the sample 208. Any of the arrangements described above with reference to **FIG. 7** to **12** may be used to achieve this functionality, including any of the various arrangements disclosed for implementing a low impedance connection between the at least one of the charged particle-optical elements maintained at ground potential and an external source of ground potential.

A method of assessing a sample 208 using charged particles is provided. The method comprises projecting charged particles toward the sample using the method of projecting charged particles toward a sample 208 discussed above. The method comprises using a charged particle-optical element comprising a detector array to detect signal particles emitted from the sample 208. The method comprises maintaining the charged particle-optical element comprising the detector array (e.g., a detector substrate in which the detector array is defined and/or the detector array) at ground potential during the detecting of the signal particles.

The descriptions above are intended to be illustrative, not limiting. Thus, it will be apparent to one skilled in the art that modifications may be made as described without departing from the scope of the claims and clauses set out below.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses:
Clause 1. A charged particle apparatus for projecting a multi-beam of charged particles toward a sample, the apparatus comprising: a sample support configured to support a sample; a charged particle-optical device configured to project beams of a multi-beam of the charged particles along a plurality of paths toward the sample, the device comprising a plurality of charged particle-optical elements that define an objective lens and in which are defined a plurality of apertures along the paths of the beams, wherein: at least two of the charged particle-optical elements are configured to be set at different potentials and at least one of the charged particle-optical elements is set at ground potential.
Clause 2. The apparatus of clause 1, wherein at least two of the charged particle-optical elements are configured to face each other.
Clause 3. The apparatus of clause 2, wherein one of the at least two charged particle-optical elements that are configured to face each other is a facing electrode defining a continuous conductive surface configured to define multiple apertures in the facing electrode and to electrostatically shield a shielded charged particle-optical element that the facing electrode faces from electric fields, desirably from electric fields upbeam of the facing electrode.
Clause 4. The apparatus of clause 3, comprising a first spacer element electrically connected to at least one of the charged particle-optical elements, desirably to at least the shielded charged particle-optical element, desirably the first spacer element being set to ground potential.
Clause 5. The apparatus of clause 3 or 4, wherein the shielded charged particle-optical element is connected to the facing electrode via the first spacer element.
Clause 6. The apparatus of clause 4 or 5, wherein the first spacer element contacts a major surface of the facing electrode on a side of the facing electrode closest to the sample.
Clause 7. The apparatus of any of clauses 4 to 6, wherein the first spacer element contacts the facing electrode on a peripheral minor surface of the facing electrode.
Clause 8. The apparatus of clause 4 or 5, wherein the first spacer element is spaced apart from the facing electrode, desirably the first spacer element being configured to define an aperture having a larger dimension than a dimension of the facing electrode, desirably in a direction across paths of the beams of the multi-beam.
Clause 9. The apparatus of any of clauses 4 to 8, further compromising a second spacer element configured to electrically isolate and support the facing electrode.
Clause 10. The apparatus of clause 9, wherein the facing electrode is connected by the second spacer element to an upbeam electrode upbeam of the facing electrode.
Clause 11. The apparatus of clause 10, wherein the second spacer element is configured to: electrically isolate the facing electrode from the upbeam electrode; and electrically connect the facing electrode to ground potential, optionally via the first spacer element.
Clause 12. The apparatus of any of clauses 4 to 11, wherein the first spacer element defines at least one conductive body forming a planar shape, desirably a closed loop or annulus, the planar shape configured to be positioned around the plurality of paths of the beams of the multi-beam, desirably surrounding the plurality of paths of the beams of the multi-beam, the at least one conductive body set to ground potential.
Clause 13. The apparatus of clause 12, wherein the at least one conductive body comprises a conductive layer, desirably a coating, on one or both sides of the first spacer element.
Clause 14. The apparatus of clause 12 or 13, wherein the at least one conductive body comprises a doped semiconductor body.
Clause 15. The apparatus of any of clauses 3 to 11, wherein the shielded charged particle-optical element comprises a detector substrate comprising a detector array, the detector array desirably comprising an array of detector elements and/or an integrated circuit in the detector substrate.
Clause 16. The apparatus of any of clauses 12 to 14, wherein the shielded charged particle-optical element comprises a detector substrate comprising a detector array, the detector array desirably comprising an array of detector elements and/or an integrated circuit in the detector substrate.
Clause 17. The apparatus of clause 16, wherein the at least one conductive body is in electrical connection with the detector array by a via through the detector substrate and/or a conductive layer, desirably a coating, desirably on a surface of the detector substrate, desirably the surface facing away from the facing electrode, desirably the conductive body being in electrical connection with the detector array and/or integrated circuit by the via and/or the conductive layer.
Clause 18. The apparatus of any of clauses 15 to 17, wherein the first spacer element contacts the detector substrate on an opposite side of the detector substrate to the sample.
Clause 19. The apparatus of any of clauses 15 to 18, wherein the detector substrate is configured to be the charged particle-optical element closest to the sample.
Clause 20. The apparatus of clause 19, wherein the detector array faces the sample.
Clause 21. The apparatus of any of clauses 15 to 20, configured to apply an offset potential to the sample via the sample support, wherein the offset potential is configured to promote propagation of signal particles emitted from the sample toward the detector array.
Clause 22. The apparatus of any of clauses 15 to 21, wherein the detector substrate is set at ground potential and/or the detector array is connected to ground potential.
Clause 23. The apparatus of any of clauses 3 to 22, wherein the facing electrode is set at ground potential.
Clause 24. The apparatus of any preceding clause, wherein the at least one of the charged particle-optical elements set at ground potential comprises an electrode of the objective lens.
Clause 25. The apparatus of any preceding clause, wherein the at least one of the charged particle-optical elements set at ground potential comprises a detector substrate comprising a detector array, the detector array desirably comprising an array of detector elements and/or an integrated circuit in the detector substrate.
Clause 26. The apparatus of any preceding clause, comprising a low impedance connection between the at least one of the charged particle-optical elements set at ground potential and an external source of ground potential.
Clause 27. The apparatus of clause 26, wherein: the apparatus comprises a cooling channel body defining a cooling channel for channeling flow of a coolant; and the low impedance connection comprises an electrical path through the cooling channel body.
Clause 28. The apparatus of clause 26 or 27, wherein: the apparatus comprises a support structure configured to mechanically support at least the plurality of charged particle-optical elements; and the low impedance connection comprises an electrical path through the support structure.
Clause 29. The apparatus of any of clauses 26 to 28, wherein the low impedance connection comprises an electrical path through a via through at least one of the charged particle-optical elements and/or an electrically conductive layer facing away from another of the charged particle-optical elements.
Clause 30. The apparatus of any preceding clause, wherein at least one of the charged particle-optical elements set to the ground potential comprises electronic circuitry.
Clause 31. The apparatus of any preceding clause, further comprising circuitry electrically connected to at least one of the charged particle-optical elements, the circuitry being remote from the charged particle-optical element and being connected to the ground potential.
Clause 32. The apparatus of any preceding clause, further comprising a plurality of position sensors, desirably level sensors, desirably capacitive sensors, desirably differential sensors, positioned on a surface of the charged particle-optical element that is configured to face a sample, the position sensors positioned around and away from the paths of the beams of the multi-beam, wherein the position sensors are connected to the ground potential, and desirably electronics associated with the position sensors are connected to the ground potential.
Clause 33. A method of projecting charged particles toward a sample, the method comprising: using a charged particle-optical device to project beams of a multi-beam of the charged particles along a plurality of paths toward the sample, the device comprising a plurality of charged particle-optical elements that define an objective lens and in which are defined a plurality of apertures along the paths of the beams; and maintaining at least two of the charged particle-optical elements at different potentials and at least one of the charged particle-optical elements at ground potential during the projecting of the beams toward the sample.
Clause 34. A method of assessing a sample using charged particles, the method comprising: projecting charged particles toward the sample using the method of clause 33; and using a charged particle-optical element comprising a detector array to detect signal particles emitted from the sample; and maintaining the charged particle-optical element comprising the detector array at ground potential during the detecting of the signal particles.
Clause 35. The method of clause 33 or 34, wherein at least two of the charged particle-optical elements face each other.
Clause 36. The method of clause 35, wherein one of the at least two charged particle-optical elements that face each other is a facing electrode defining a continuous conductive surface defining multiple apertures in the facing electrode and electrostatically shielding a shielded charged particle-optical element that the facing electrode faces from electric fields, desirably from electric fields upbeam of the facing electrode.
Clause 37. The method of clause 36, wherein a first spacer element is electrically connected to at least one of the charged particle-optical elements, desirably to at least the shielded charged particle-optical element, desirably the first spacer element being set to ground potential.
Clause 38. The method of clause 36 or 37, wherein the shielded charged particle-optical element is connected to the facing electrode via the first spacer element.
Clause 39. The method of clause 37 or 38, wherein the first spacer element contacts a major surface of the facing electrode on a side of the facing electrode closest to the sample.
Clause 40. The method of any of clauses 37 to 39, wherein the first spacer element contacts the facing electrode on a peripheral minor surface of the facing electrode.
Clause 41. The method of clause 37 or 38, wherein the first spacer element is spaced apart from the facing electrode, desirably the first spacer element defining an aperture having a larger dimension than a dimension of the facing electrode, desirably in a direction across paths of the beams of the multi-beam.
Clause 42. The method of any of clauses 37 to 41, wherein a second spacer element electrically isolates and supports the facing electrode.
Clause 43. The method of clause 42, wherein the facing electrode is connected by the second spacer element to an upbeam electrode upbeam of the facing electrode.
Clause 44. The method of clause 43, wherein the second spacer element: electrically isolates the facing electrode from the upbeam electrode; and electrically connects the facing electrode to ground potential, optionally via the first spacer element.
Clause 45. The method of any of clauses 37 to 44, wherein the first spacer element defines at least one conductive body forming a planar shape, desirably a closed loop or annulus, the planar shape positioned around the plurality of paths of the beams of the multi-beam, desirably surrounding the plurality of paths of the beams of the multi-beam, the at least one conductive body set to ground potential.
Clause 46. The method of clause 45, wherein the at least one conductive body comprises a conductive layer, desirably a coating, on one or both sides of the first spacer element.
Clause 47. The method of clause 45 or 46, wherein the at least one conductive body comprises a doped semiconductor body.
Clause 48. The method of any of clauses 36 to 44, wherein the shielded charged particle-optical element comprises a detector substrate comprising a detector array, the detector array desirably comprising an array of detector elements and/or an integrated circuit in the detector substrate.
Clause 49. The method of any of clauses 45 to 47, wherein the shielded charged particle-optical element comprises a detector substrate comprising a detector array, the detector array desirably comprising an array of detector elements and/or an integrated circuit in the detector substrate.
Clause 50. The method of clause 49, wherein the at least one conductive body is in electrical connection with the detector array by a via through the detector substrate and/or a conductive layer, desirably a coating, desirably on a surface of the detector substrate, desirably the surface facing away from the facing electrode, desirably the conductive body being in electrical connection with the detector array and/or integrated circuit by the via and/or the conductive layer.
Clause 51. The method of any of clauses 48 to 50, wherein the first spacer element contacts the detector substrate on an opposite side of the detector substrate to the sample.
Clause 52. The method of any of clauses 48 to 51, wherein the detector substrate is the charged particle-optical element closest to the sample.
Clause 53. The method of clause 52, wherein the detector array faces the sample.
Clause 54. The method of any of clauses 48 to 53, comprising applying an offset potential to the sample via the sample support, wherein the offset potential promotes propagation of signal particles emitted from the sample toward the detector array.
Clause 55. The method of any of clauses 48 to 54, wherein the detector substrate is set at ground potential and/or the detector array is connected to ground potential.
Clause 56. The method of any of clauses 36 to 55, wherein the facing electrode is set at ground potential.
Clause 57. The method of any of clauses 33 to 56, wherein the at least one of the charged particle-optical elements set at ground potential comprises an electrode of the objective lens.
Clause 58. The method of any of clauses 33 to 57, wherein the at least one of the charged particle-optical elements set at ground potential comprises a detector substrate comprising a detector array, the detector array desirably comprising an array of detector elements and/or an integrated circuit in the detector substrate.
Clause 59. The method of any of clauses 33 to 58, comprising a low impedance connection between the at least one of the charged particle-optical elements set at ground potential and an external source of ground potential.
Clause 60. The method of clause 59, wherein: a cooling channel body defines a cooling channel for channeling flow of a coolant; and the low impedance connection comprises an electrical path through the cooling channel body.
Clause 61. The method of clause 59 or 60, wherein: a support structure mechanically supports at least the plurality of charged particle-optical elements; and the low impedance connection comprises an electrical path through the support structure.
Clause 62. The method of any of clauses 59 to 61, wherein the low impedance connection comprises an electrical path through a via through at least one of the charged particle-optical elements and/or an electrically conductive layer facing away from another of the charged particle-optical elements.
Clause 63. The method of any of clauses 33 to 62, wherein at least one of the charged particle-optical elements set to the ground potential comprises electronic circuitry.
Clause 64. The method of any of clauses 33 to 63, wherein circuitry is electrically connected to at least one of the charged particle-optical elements, the circuitry being remote from the charged particle-optical element and being connected to the ground potential.
Clause 65. The method of any of clauses 33 to 64, wherein a plurality of position sensors, desirably level sensors, desirably capacitive sensors, desirably differential sensors, are positioned on a surface of the charged particle-optical element that faces a sample, the position sensors positioned around and away from the paths of the beams of the multi-beam, wherein the position sensors are connected to the ground potential, and desirably electronics associated with the position sensors are connected to the ground potential.

## Claims

1. A charged particle apparatus for projecting a multi-beam of charged particles toward a sample, the apparatus comprising:
a sample support configured to support a sample;
a charged particle-optical device configured to project beams of a multi-beam of the charged particles along a plurality of paths toward the sample, the device comprising a plurality of charged particle-optical elements that define an objective lens and in which are defined a plurality of apertures along the paths of the beams, wherein:
at least two of the charged particle-optical elements are configured to be set at different potentials and at least one of the charged particle-optical elements is set at ground potential.

2. The apparatus of claim 1, wherein at least two of the charged particle-optical elements are configured to face each other.

3. The apparatus of claim 2, wherein one of the at least two charged particle-optical elements that are configured to face each other is a facing electrode defining a continuous conductive surface configured to define multiple apertures in the facing electrode and to electrostatically shield a shielded charged particle-optical element that the facing electrode faces from electric fields, desirably from electric fields upbeam of the facing electrode.

4. The apparatus of claim 3, comprising a first spacer element electrically connected to at least one of the charged particle-optical elements, desirably to at least the shielded charged particle-optical element, desirably the first spacer element being set to ground potential.

5. The apparatus of claim 3 or 4, wherein the shielded charged particle-optical element is connected to the facing electrode via the first spacer element.

6. The apparatus of claim 4 or 5, wherein the first spacer element contacts a major surface of the facing electrode on a side of the facing electrode closest to the sample and/or the first spacer element contacts the facing electrode on a peripheral minor surface of the facing electrode.

7. The apparatus of claim 4 or 5, wherein the first spacer element is spaced apart from the facing electrode, desirably the first spacer element being configured to define an aperture having a larger dimension than a dimension of the facing electrode, desirably in a direction across paths of the beams of the multi-beam.

8. The apparatus of any of claims 4 to 7, further compromising a second spacer element configured to electrically isolate and support the facing electrode.

9. The apparatus of claim 8, the facing electrode being connected by the second spacer element to an upbeam electrode upbeam of the facing electrode, wherein the second spacer element is configured to:
electrically isolate the facing electrode from the upbeam electrode; and
electrically connect the facing electrode to ground potential, optionally via the first spacer element.

10. The apparatus of any of claims 4 to 9, wherein the first spacer element defines at least one conductive body forming a planar shape, desirably a closed loop or annulus, the planar shape configured to be positioned around the plurality of paths of the beams of the multi-beam, desirably surrounding the plurality of paths of the beams of the multi-beam, the at least one conductive body set to ground potential.

11. The apparatus of any of claims 3 to 10, wherein the shielded charged particle-optical element comprises a detector substrate comprising a detector array, the detector array desirably comprising an array of detector elements and/or an integrated circuit in the detector substrate.

12. The apparatus of claim 11, wherein the first spacer element contacts the detector substrate on an opposite side of the detector substrate to the sample.

13. The apparatus of claim 11 or 12, wherein the detector substrate is set at ground potential and/or the detector array is connected to ground potential.

14. The apparatus of any preceding claim, comprising a low impedance connection between the at least one of the charged particle-optical elements set at ground potential and an external source of ground potential.

15. A method of projecting charged particles toward a sample, the method comprising:
using a charged particle-optical device to project beams of a multi-beam of the charged particles along a plurality of paths toward the sample, the device comprising a plurality of charged particle-optical elements that define an objective lens and in which are defined a plurality of apertures along the paths of the beams; and
maintaining at least two of the charged particle-optical elements at different potentials and at least one of the charged particle-optical elements at ground potential during the projecting of the beams toward the sample.
